# EUROPEAN PATENT APPLICATION

(11) **EP 2 637 074 A2**
(43) Date of publication of application: **11.09.2013**
(21) Application number: 13158315.5
(22) Date of filing: 08.03.2013
(51) Int. Cl.: G06F 1/20, H05K 7/20

(54) **Open air cooled and locally coolable information processing system and load allocation method in such system**

(30) Priority: 08.03.2012 JP 2012051524; 28.02.2013 JP 2013038171
(71) Applicant: Hitachi Ltd., Tokyo 100-8280 (JP)
(72) Inventor: Shimizu, Hayato, Tokyo 100-8220 (JP)
(74) Representative: Beetz & Partner

(57) **Abstract**

There are provided a practical open air cooled information processing system in which a back stream or recirculation of cooling air does not occur, as well as a load allocation method in such system. A temperature sensor (105) is provided in the cooling air inlet of each server (13). When increasing the number of servers (13) in operation, checking out which one of servers (13) out of operation, when activated, brings a results of minimizing a maximum value of the intake air temperatures of servers (13) in operation and then activating the one of the servers (13) are performed. Inversely, when decreasing the number of servers (13) in operation, deactivating a server (13) activated last is performed. It is avoided that, due to utilizing consolidation and using cooling equipment that takes in open air together, a back stream or recirculation of cooling air occurs, resulting in a fault such as an abnormal intake air temperature of a certain server (13).

## Description

### FIELD OF THE INVENTION

The present invention relates to a so-called, open air cooled information processing system such as an open air cooled data center comprised of a cluster of information processing devices such as server machines and cooling equipment for cooling these devices and an operation management method of the information processing devices in such system. In particular, the present invention relates to an open air cooled information processing system or a locally coolable information processing system and a method for allocating workloads to information processing devices in a cluster in such system.

### BACKGROUND OF THE INVENTION

Currently, with increase in the amount of heat generated by information processing devices such as server machines which augment exclusively, cooling electricity, i.e., electric power consumed by cooling equipment for cooling the heat generated also increases. A problem encountered is to save overall electricity, a total of both electric power consumed by the server machines and the cooling electricity.

With the aim of electric power saving of a data center, various approaches are made to save electric power in regard to information processing devices such as server machines, cooling equipment, and operation management, respectively.

With respect to the information processing devices, for example, improving performance per wattage consumed through the use of low-power devices and exercising a power-saving function by operating state changeover depending on workload are promoted.

With respect to the cooling equipment, it is contrived to accomplish electric power saving by taking in open air and carrying out cooling by air blow only, unlike a heat pump type which uses a compressor in air conditioning.

In addition, with respect to the operation management, monitoring operative/inoperative status information, job scheduling, and improving the operation efficiency of devices in a cluster and consolidation by means of virtualization, etc. performed.

Cooling equipment is generally designed based on a total maximum rated power of server machines in a cluster. In practical operation, however, all server machines may not be necessarily used at the same time and the load of a server machine used may not always reach a maximum load.

In future, as operation management technology for data centers will evolve, consolidation of server machines for electric power saving using virtualization technology is foreseen to be utilized. In addition, cooling equipment that takes in open air is foreseen to be used together or locally cooling equipment with a plurality of air conditioning units is foreseen to be used together. In this foreseen situation, uneven distribution of electric power across devices in a cluster may cause a back stream or recirculation of cooling airflow. In consequence, rather adversely, there is a possibility that heat accumulation takes place and results in a fault such as an abnormal intake air temperature of a curtain server.

Until now, as operation management methods for activating and deactivating servers depending on their loads, some patent documents which will be outlined below have already been known.

First according to Japanese Published Unexamined Patent Application No. 2011-40083 mentioned below, operation management of an information, processing system comprised of a cluster of information processing devices such as servers, storages, and a network and equipment for supplying power to or cooling these devices is implemented such that allocation of workloads to the devices in the cluster and operation simulation of the equipment are executed in a common virtual space in a.n integrated manner by reproducing, in the virtual space, the operative/inoperative statutes of the devices in the cluster and the equipment and how the devices and the equipment are deployed in a rear space. In particular, this document provides a technique suitable for carrying out integrated power-saving operation management of the information processing devices in the cluster and the equipment.

Then, Japanese Published Unexamined Patent Application No. 2008-171427 mentioned below provides a method for determining an optimal order for reactivating (rebooting) a plurality of servers in a data center. In this method, reactivation is performed in order that is based on an activation order decision policy and it is suggested to provide activation so as to derive proper levels of electric power and wattages.

In addition, in Japanese Published Unexamined Patent Application No. 2011-82799 mentioned below, it is described that, in providing computing resources to a customer system, each data center has knowledge of electric power consumption needed to provide computing resources as electric power information in which an amount of power consumption required for computing resources demanded can be specified and suitable operation of computing resources is implemented by taking such information into account.

As noted above, a feature of the operation management technique according to Japanese Published Unexamined Patent Application No. 2011-40083 above is that allocation of workloads to the devices in the cluster and operation stimulation of the equipment are executed in a common virtual space in an integrated manner by reproducing, in the virtual space, the operative/inoperative statuses of the devices in the cluster and the equipment and how the devices and the equipment are deployed. To do this, however, voluminous computation is needed for operation simulation. For example, if a fan for the servers can be put in two operational states, "stop" and "run", and if there are N servers, simulation runs as many as 2 raised to the Nth power are needed.

In Japanese Published Unexamined Patent Application No. 2008-171427 above, it is stated that reactivation is performed in order that is based on an activation order decision policy, but there is no description about how to determine such policy. Further, in Japanese Published Unexamined Patent Application No. 2011-82799 above, it is stated that a data center has electric power information in which an amount of power consumption, required for computing resources demanded can be specified. However, unless such electric power information must be held beforehand as data obtained, through numerous case study runs, it is inadequate for actual operation.

In the related art techniques described above, voluminous computation and creating a database by case study runs are need to determine an order in which to activate and deactivate servers. These techniques have a problem in which it takes huge cost to make preparations for putting a system into operation.

### SUMMARY OF THE INVENTION

Therefore, the present invention has been achieved in view of the problem of the related art techniques described above. More specifically, an object of the present invention is to provide an open air cooled information processing system that is more practical and makes the problem, of the related art techniques described above less likely to occur and a load allocation method in such system.

In order to achieve the foregoing object, according to the present invention, there is provided a load allocation method for allocating loads to information processing devices in an open air cooled information processing system that takes in open air and cools a plurality of information processing devices by single air blowing unit. The information processing devices are each positioned across an interface between one space into which open air is taken in and another space into which air after cooling the information processing devices is collected. The load allocation method includes the following steps: when decreasing the number of servers in operation, determining which one of the servers in operation, should be deactivated so as to minimize electric power consumed by the air blowing unit by way of numerical analysis performed individually on each of the servers in operation and according to a. change in intake air temperature of each server and deactivating the one of the servers; and, when increasing the number of servers in operation, determining which one of the servers out of operation should be activated, so as to minimize electric power consumed by the air blowing unit by way of numerical analysis in an inoperative status performed individually on each of the servers out of operation and according to a change in the intake air temperature of each server, and activating the one of the servers.

In another aspect, there is provided a load allocation method in a locally coolable information processing system that cools a plurality of information processing devices by a plurality of air conditioning units adjoining these devices. In the information processing system, the information processing devices are arranged to lie between one space into which cool air supplied by air conditioning units flows in and a space in which air after cooling the information processing devices is collected to the intake side of the air conditioning units adjoining the devices. The method for allocating loads to these information processing devices is performed in the same way as in the foregoing open air cooled air processing system.

In the present invention, in the load allocation method in the open air cooled or locally coolable information processing system, described above, the above numerical analysis may be performed before start of operation. The load allocation method may preferably include the following steps: setting, as a first server, a server when activated that is determined to bring a result of minimizing the electric power consumed by the air blowing unit and not to make an abnormal change of the intake air temperature of the server, assuming a case where one server has been activated from a state in which all severs are inoperative; setting, as a second server, a server when activated that brings a result of minimizing the electric power consumed by the air blowing unit and does not make an abnormal change of the intake air temperature of the server, assuming a case where one server has further been activated from a state in which the first server is operative; setting, as an n-th server (where n is a natural number smaller than the number of all server), a server when activated that brings a result of minimizing the electric power consumed by the air blowing unit and does not make an abnormal change of the intake air temperature of the server, assuming a case where an (n+1)th server has been activated from a state in which the n-th server is operative; and repeating the step of setting a server as the n-th server until a state in which only one of all servers is operative and storing an order of the servers thus obtained.

According to the present invention and also in order to achieve the foregoing object, there is provides an open air cooled information processing system that takes in open air and cools a plurality of information processing devices by single air blowing unit. The information processing devices are each positioned across an interface between, one space into which open air is taken in and another space into which air after cooling the information processing devices is collected. Each of the servers includes means for measuring its intake air temperature. The open air cooled, information processing system includes: means for, when decreasing the number of servers in operation, determining which one of the servers in operation should be deactivated so as to minimize electric power consumed by the air blowing unit by way of numerical analysis performed individually on each of the servers in operation and according to a change in the intake air temperature of each server, and deactivating the one of the servers; and means for, when increasing the number of servers in operation, determining which one of the servers out of operation should be activated so as to minimize electric power consumed by the air blowing unit by way of numerical analysis in as inoperative status performed individually on each of the servers out of operation and according to a change in the intake air temperature of each server, and activating the one of the servers. In a similar manner, a locally coolable information processing system is also provided.

According to the present invention described above, it is possible to activate servers in order ensuring that a back stream is always prevented from occurring or has little impact even if occurred. Thus, when a aback stream has occurred, the output of the cooling air blower fan required to get rid of it can be minimized. Even if some of server machines are deactivated for electric power saving, it will be possible to avoid that the deactivation results in a fault such as an abnormal intake air temperature of a certain server. Moreover, the present invention is to determine an optimal order in which to activate servers from moment to moment during operation. In a case where consolidation of server machines is utilized for electric power saving and, besides, cooling equipment that takes in open air is used together, uneven distribution of electric power across devices in a cluster may cause a back stream or recirculation of cooling airflow. In consequence, heat accumulation may take place and result in a fault such as an abnormal intake air temperature of a certain server. It will also be possible to avoid this.

### BRIEF DESCRIPTION OF THE DRAWINGS

Fig. 1 is a block diagram showing an example of a configuration of an open air cooled information processing system to which a workload allocation method of the present invention is applied;
Fig. 2 is a diagram representing detail of a cooling airflow produced by taking in open air in the above system and depicting an example of explaining a load allocation sequence;
Fig. 3 is a flowchart illustrating operations when activating a server in the above open air cooled information processing system;
Fig. 4 is a flowchart illustrating operations when deactivating a server in the above open air cooled information processing system;
Fig. 5 is a diagram explaining one example of a configuration of a locally coolable information processing system to which the workload allocation method of the present invention is applied;
Fig. 6 is a diagram explaining another example of a configuration of a locally coolable information processing system to which the workload allocation method of the present invention is applied;
Fig. 7 is a block diagram depicting one example of a configuration of a locally coolable information processing system to which the workload allocation method of the present invention is applied; and
Fig. 8 is a flowchart illustrating an operation when deactivating an air conditioning unit in the above locally coolable information processing system.

### DETAILED DESCRIPTION OF THE PREFERRED EMBODIMENTS

In the following, an embodiment of the present invention will be described in detail with reference to the accompanying drawings.

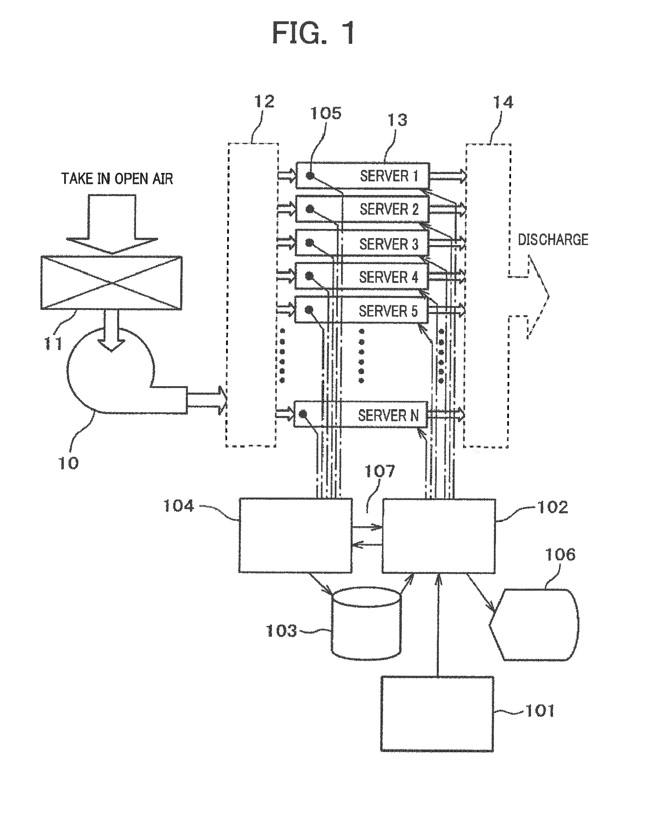

First, Fig. 1 is a block diagram showing an example of a configuration of an open air cooled information processing system to which a workload allocation method, in which the present invention is embodied, is applied. This figure depicts a system configuration in which N information processing devices 13 such as servers are installed and cooling equipment (open air cooling equipment) which will be described below is provided to cool these servers 13.

First, cooling airflow produced by taking in open air is described. When open air is taken in (see a flow represented by outline arrows in the figure), impurities (e.g., dust) in the open air, are eliminated and the air humidity is conditioned by means for conditioning taken-in open air such as, e.g., a filter, namely, open air conditioning means 11. The air from the open air conditioning means 11 is then sent into a space 12 (so-called, cold aisle) onto which the cooling air inlets of the servers are open by a fan 10 that supplies the air as cooling air to a cluster of the above servers 13. Then, the air, after cooling the above servers 13 in the cluster, is collected into a space 14 (so-called hot aisle) onto which the outlets of the servers are open and discharged outside again.

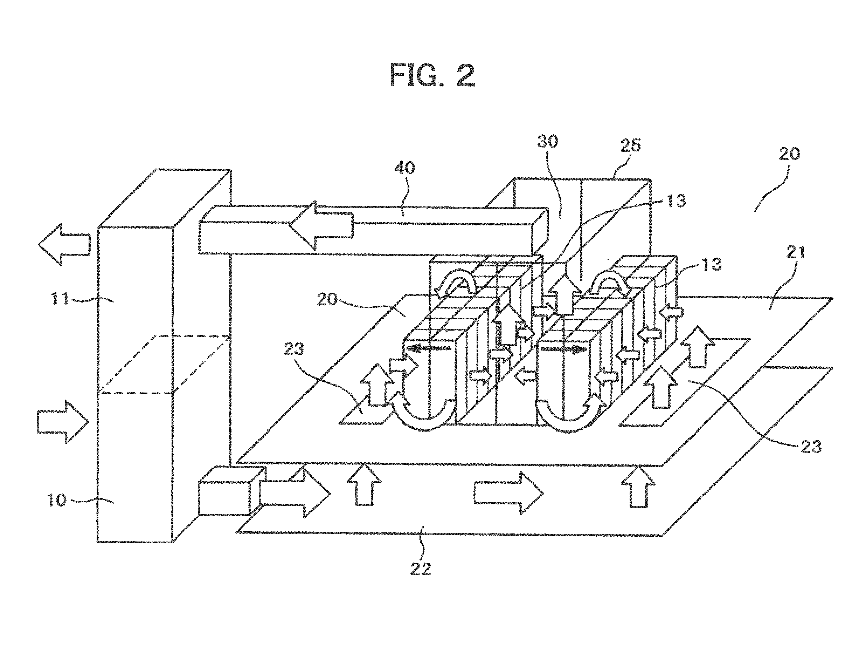

Fig. 2 attached shows, by way of example, an internal construction of an open air cooled data center in order to represent detail of the above cooling airflow produced by taking in open air. In this figure, components corresponding to those shown in Fig. 1 above are maked with the same reference numerals.

In the open air cooled data center shown, required cooling air is supplied to multiple (N) servers 13 by a single cooling air blower fan 10 (configured to be integral with the open air conditioning means 11). The cooling air inlets of the servers 13 (arranged in two arrays in this example) are open onto the cold aisle in the space of the center. More specifically, this cold aisle 20 is a space defined by ceiling, wall, and floor surface in the space of the center, not shown, (excluding the hot aisle defined by aisle capping which will be described later). Cooling air from the above cooling air blower fan 10 (see a flow represented by outline arrows in the figure) passes through a space between the floor 21 and the underfloor base 22 of the center and through openings 22 and is then supplied to the above cold aisle 20 (see the flow represented by outline arrows in the figure).

In the figure, the servers 13 in two arrays are placed with their back sides facing each other and so-called aisle capping 25, which is a partition made of, e.g., transparent plastic sheets or the like, is provided to enclose a space around the back sides of the servers (that is, the space onto which the outlets of the servers are open). By the provision of the aisle capping 25, open air supplied as cooling air into the above cold aisle 20, after cooling the servers 13 in the cluster, is discharged into the space enclosed by the aisle capping 25, namely, the hot aisle 30. Then, the air (hot air) collected into the hot aisle 30 after cooling is circulated to the open air conditioning means 11 through an exhaust duct 40 and discharged to open air again.

That is, the cold aisle 20 and the hot aisle 30 are isolated from each other so that the airs in them are not mixed. Consequently, in the space of the center, because air warmed by heat generated by servers 13 does not increase again the temperature of air that is sucked into other servers 13, the cooling air blower fan 10 is only required to supply a total sum of air volumes demanded by each server 13.

However, according to experiments performed by the present inventors, we have found that, when consolidation of server machines for electric power saving is performed in the foregoing state of the data center, deactivation of a server, when occurs, produces a bypass flow passage through which air can flow back in the server (space inside its housing), because the server's blower fan stops (see a flow represented by a solid arrow in the figure). This poses the following problem. As such a back stream occurs and becomes stronger, a back stream or recirculation of cooling air takes place in the airflow that is flowing until then from the cold aisle 20 toward the hot aisle 30, and eventually heat accumulation takes place. In consequence, to eliminate this problem, it is necessary to increase the output of the cooling air blower fan 10. This adversely results in that electric power required for air conditioning increases to increase the fan output (despite the fact that a server is deactivated).

Thus, in the present invention, to address the foregoing problem, countermeasures are takes as below. Since the intake air temperature of a server rises when a back stream takes place, a temperature sensor (reference numeral 105 in Fig. 1) that operates independently of server operation is provided in the inlet of a server. Accordingly, a back stream occurring can be detected by monitoring for rise/fall in temperature measured by the sensor. Based on this, when increasing the number of servers in operation, the following steps are executed: checking out which one of servers out of operation, when activated, brings a result of minimizing a maximum value of the intake air temperatures of servers in operation and then activating the of the servers. Inversely, when decreasing the number of servers in operation, deactivating a server activated last is performed.

### [First Embodiment]

Now, returning to Fig. 1 again, as a first embodiment in which the present invention is embodied, descriptions are provided with regard to activating a new server. In Fig. 1, reference numeral 101 denotes a server load increase/decrease noticing device for giving notice of an increase/decrease in server load; reference numeral 102 denotes a server activation/deactivation commanding and executing device that commands and executes activation/deactivation of each server; reference numeral 103 denotes a storage device embodied by, e.g., a memory for storing an order in which to active/deactivate servers; and reference numeral 104 denotes server and air conditioning unit determining unit that collects information on the operative/inoperative statuses and the temperatures of the servers and determines one server to be activated, based on such information. These devices can be embodied by a CPU or the like including a memory having programs stored therein for implementing operations specific to the respective devices. Reference numeral 106 in the figure denotes a monitor displaying the operative/inoperative statuses of the servers and reference numeral 107 denotes communication unit (e.g., a data bus or the like) for communicating a request to activate/deactivate one unit of server and its operative/inoperative status to each component involved.

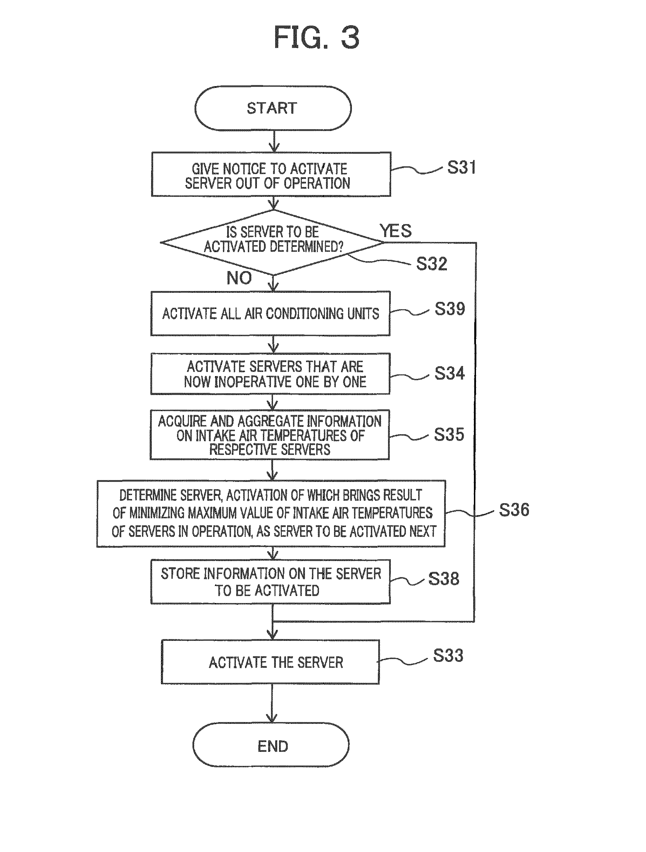

For activating a new server, in the open air cooled information processing system (open air cooled data center) configured as described previously, the server load increase/decrease noticing device 101 that gives notice of an increase/decrease in server load gives notice to activate a server out of operation to the server activation/deactivation commanding and executing devise 102 that commands and executes activation/deactivation of each server (step S31). Upon receiving this instruction, the server activation/deactivation commanding and executing device 102 refers to the server and air conditioning unit activation/deactivation order storing device 103, and determines whether a. server to be activated is determined (step S32). In other words, it determines whether or not one server to be activated from the current status is stored in the storing device 103, and, if a server to be activated is stored ("Yes" in Fig. 3), activates the server (step S33).

Otherwise, if the storing device does not have information on a server to be activated, as determined at step S31 above ("No" in fig. 3), the operative/inoperative statuses of the servers are notified to the server and air conditioning unit determining unit 104 that collects information on the operative/inoperative statuses and the temperatures of the servers and determines one server to be activated. At this point, in a locally coolable information processing system which will be described later, prior to executing step S34 and subsequent steps, all air conditioning units are activated once (step S39). This can prevent an abnormal increase of inlet air temperature which may occur inadvertently due to a server that is newly activated. However, this stew S39 may be dispensed with in the open air cooled information processing system. By step S34 and subsequent steps, the server and air conditioning unit determining unit 104 activates servers that are now inoperative one by one through, the above server activation/deactivation cominanding and executing device (step S34). Then, the server and air conditioning unit determining unit 104 acquires and aggregates information on the intake air temperatures of the respective servers from the intake air teinperature sensors 105 of the servers and performs numerical analysis (step S35). According to this analysis, the server and air conditioning unit determining unit 104 determiners a server, activation of which brought a result of minimizing a maximum value of the intake air temperatures of the servers in operation, as one server to be activated (step S36). Then, the server determined to be activated is activated through the server activation/deactivation commanding and executing device 102 (step S37). At the same time, information on the activated server is stored (step S38). In this May, a possibility is provided to activate a server in which a back stream is least likely to occur, namely, an optimal server.

Stated differently, when decreasing the number of servers in operation, the following steps are executed: determining which one of the servers in operation, should be deactivated so as to minimize electric power consumed by the air blower (cooling air blower fan 10) by way of numerical analysis performed individually on each of the servers in operation, judging whether or not an abnormal change in the intake air temperature of each server occurs, and deactivating the thus determined server. On the other hand, when increasing the number of servers in operation, the following step is executed: determining which one of the servers out of operation should be activated so as to minimize electric power consumed by the air blowing unit by way of numerical analysis in inoperative status performed individually on each of the servers out of operation and according to a change in the intake air temperature of each server.

The foregoing numerical analysis may be performed before start of operation. In such a case, it is preferable to execute the following steps: setting, as a first server, a server when activated that is determined to bring a result of minimizing the electric power consumed by the above air blowing unit and not to make an abnormal change of the intake air temperature of the server, assuming a case where one server has been activated, from a state in which all severs are inoperative; setting, as a second server, a server when activated that brings a result of minimizing the electric power consumed by the above air blowing unit and does not make an abnormal change of the intake air temperature of the server, assuming a case wtiere one server has further been activated from a state in which the first server is operative; setting, as an n-th server (where n is a natural number smaller than the number of all server), a server when activated that brings a result of minimizing the electric power consumed by the above air blowing unit and does not make an abnormal change of the intake air temperature of the server, assuming a case where an (n+1)th server has been activated from a state in which the n-th server is operative; and repeating the step of setting a server as the n-th server until a state in which only one of all servers is operative and storing an order of the servers thus obtained.

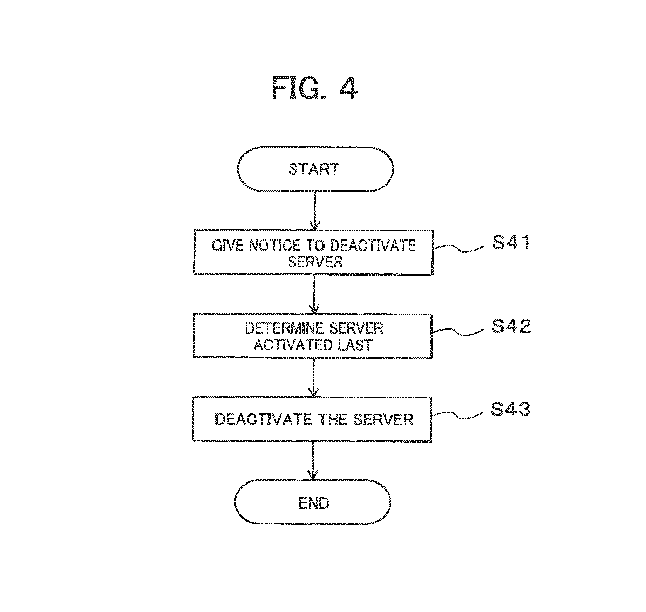

Next, descriptions are provided with regard to deactivating a server in operation with reference to Fig. 4. First, when the server load increase/decrease noticing device 101 gives notice to deactivate a server (step S41), the server activation/deactivation commanding and executing device 102 refers to the server and air conditioning unit activation/deactivation order storing device 103, determines a server activated, last (step S42), and deactivates the server (step S43). Here, as for all servers in operation, the order in which they are activated is stored beforehand in the above server and air conditioning unit activation/deactivation older storing device 103, as apparent from the foregoing description, and a server activated last is evidently a server optimal to be deactivated.

Information stored in the above server and air conditioning unit activation/deactivation order storing device 103 is valid, unless a change is made to the configuration of servers or the like. Next time and subsequently, the operative/inoperative statuses of the servers are notified to the server and air conditioning unit determining unit 104 that collects information on the operative/inoperative statuses and the temperatures of the servers and determines one server to be activated. Then, the server and air conditioning unit determining unit 104 activates servers that are now inoperative one by one through the server activation/deactivation cominariding and executing device 102 and acquires and aggregates information on the intake air temperatures of the respective servers from the intake air temperature sensors 105 of the servers. Thereby, it is possible to dispense with the operation of determining one server to be activated, as a server, activation of which brought a result of minimizing a maximum value of the intake air temperatures of the servers in operation.

### [Second Embodiment]

In the above embodiment, among the devices that execute above-described operations, it has been explained that the server and air conditioning unit determining unit 104 is a device that collects information on the operative/inoperative statuses and the temperatures of the servers and determines one server to be activated. However, the present invention is not so limited. The server and air conditioning unit determining unit 104 for determining one server to be activated may execute simulation discussed in Japanese Published Unexamined Patent Application No. 2011-40083 mentioned previously.

Even in a case where simulation is executed, according to the foregoing present invention, simulation runs as many as 2 raised to the Nth power, as mentioned previously, need not be performed, but the simulation runs can be reduced to N times. More specifically, if, for example, the number of servers is 20, simulation runs as many as 2 raised to the 20th power (= 1048576) can be reduced to 20 times.

### [Third Embodiment]

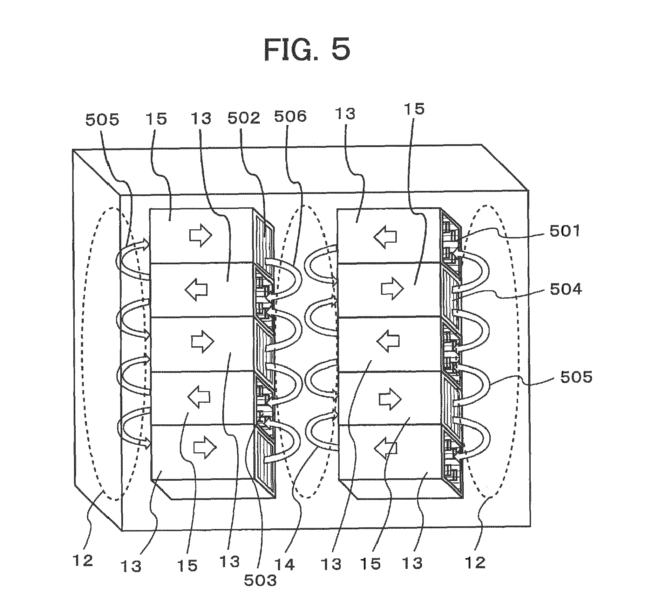

Using Figs. 5 through 8, descriptions are then provided about a locally coolable information processing system and its specific configuration and operation as another embodiment of the present invention different from the open air cooled information processing system. Other aspects of the configuration and operation than as will be described below are the same as for the open air cooled information processing system.

Fig. 5 is an overhead view of one example of a locally coolable system where air conditioning units and racks, in each of which a server is accommodated, are arranged in one array. In the figure, reference numeral 13 denotes a rack in which a server is accommodated and reference numeral 15 denotes an air conditioning unit. Although, in this example, an example of layout in which each air conditioning unit and each rack are arrayed alternately is presented, air conditioning units may be arranged such that every two of them are placed to sandwich two or more server racks between them. Each server has an air blowing mechanism for ventilating itself so that air will flow toward a constant direction. Likewise, each air conditioning unit also has a heat exchanger and an air blowing mechanism as a minimum configuration inside it so that air will also flow toward a constant direction. Air blowing directions are indicated by arrows on the top surfaces of structures denoted by 13 and 15 in the figure. Thus, reference numerals 501 and 502 denote the inlet and the outlet of a server rack (13), respectively. Then, reference numerals 503 and 504 denote the intake and the discharge port of an air conditioning unit, respectively, Because a server rack (13) usually generates heat, air temperature at its outlet 502 becomes higher than air temperature at its inlet. 501. Because an air conditioning unit (15) usually operates for cooling, air temperature at its discharge port 504 becomes lower than air temperature at its intake 503. The discharge port 504 of each air conditioning unit (15) faces a space 12 onto which the cooling air inlets of servers are open so that the air conditioning unit discharges air into the space 12. Inversely, the intake (503) of each air conditioning unit (15) faces a space 14 onto which the outlets of servers are open so that it takes in air from the space 14. While Fig. 5 presents an, example in which, servers and air conditioning units are arranged in two arrays, the servers and air conditioning units in each array are placed in close contact with each other so that the airs in the spaces 12 14 are not mixed directly. There may be any number of arrays, provided that the arrays are arranged alternately to share the spaces 14 and 12.

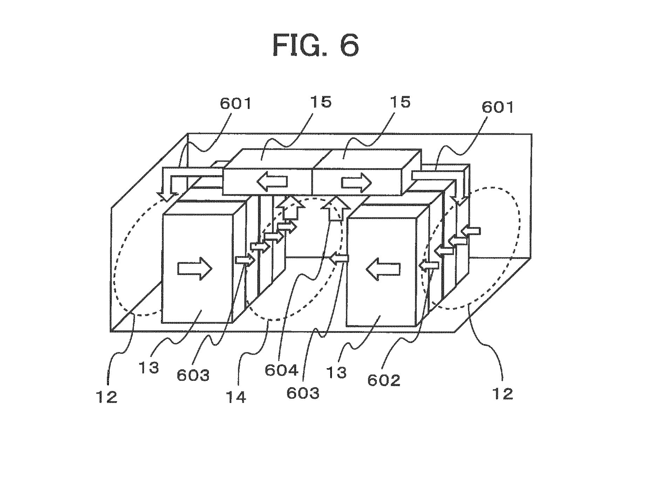

Next, Fig. 6 is an overhead view of another example of a locally coolable system where air conditioning units are arranged to be suspended from the ceiling. Reference numerals in the figure are the same as in Fig. 5; reference numeral 13 denotes a rack in which a server was accommodated and reference numeral 15 denotes an air conditioning unit. This exainple presents a type in which air conditioning units are suspended from the ceiling, but how they are attached to the ceiling and suspended and piping to outside omitted from. Fig. 6. In this example also, each air conditioning unit has a heat exchanger and an air blowing mechanism as a minimum configuration inside it. Air blowing directions are indicated by arrows on the side surfaces of the structures of server 13 and air conditioning units 15 in the figure. Air flowing into the servers is indicated by an arrow 602 and air flowing out of them is indicated by an arrow 603. Each air conditioning unit (15) blows cool air into a space 12 onto which the cooling air inlets of servers are open, as indicated by an arrow 601, and, inversely, takes in air from a space 14 onto which the outlets of servers are open, as indicated by an arrow 604. While Fig. 6 presents an examle in which servers are arranged in two arrays, the servers in each array are placed in contact with each other so that the airs in the spaces 12 and 14 are not mixed directly. There may be any number of arrays, provided that the arrays are aranged alternately to share the spaces 14 and 12. The number of air conditioning units may be any number as required.

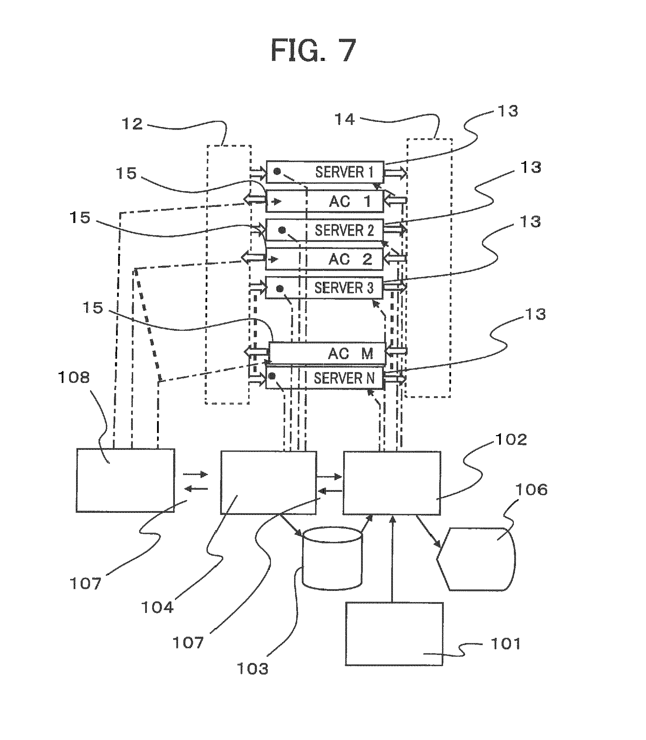

Next, Fig. 7 is a block diagram depicting a configuration of a locally coolable information processing system of the present invention. Reference numerals in the figure denote the identical elements of the open air cooled information processing system in Fig. 1 and these elements operate the same as described previously. Aspects different from the open air cooled information processing system will be described below. The locally coolable information processing system dispenses with the fan 10 and the open air conditioning unit 11 which exist in the open air cooled system in Fig. 1 with regard to taking in open, air. There is no exhaust duct and the spaces 12 and 14 are closed indoors. Here is presented a case where there are N servers 13 and M air conditioning units. All air conditioning units are positioned to take in air from the space 14 into which the servers discharge air and discharge air into the space 12 from which the servers take in air. Obviously, any of the locally coolable systems described with Figs. 5 and 6 can be represented by this block diagram. Further, this system includes unit 108 for controlling the M air conditioning units individually. The unit 108 operates an air conditioning unit to be put into operation now, determined by server and air conditioning unit determining unit 104, and acquires information such as intake and discharge air temperatures reflecting a state of operation of air conditioning units and electric power consumed. Acquired information is transferred to the server and air conditioning unit determining unit 104 via a communication unit 107. The server and air conditioning unit determining unit 104 performs an operation of determining a state of operation of air conditioning units in addition to its task in the open air cooled system in Fig. 1.

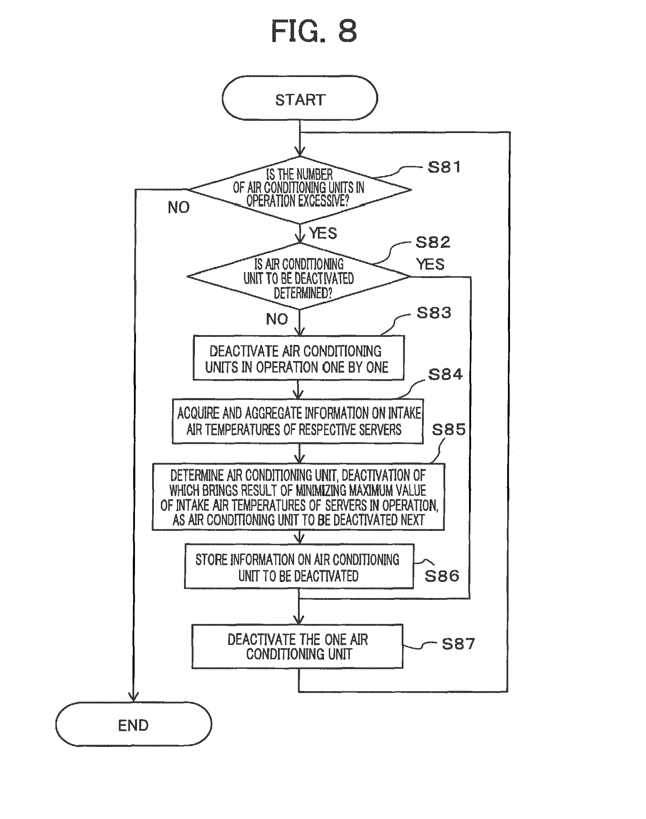

Fig. 8 is a flowchart of the operation for determining a state of operation of air conditioning units. In the locally coolable system also, the procedural flow of determining a server to be activated (Fig. 3) and the procedural flow with regard to deactivating a server (Fig. 4) are exexuted in the same way as is the case in the open air cooled system. At timing immediately after the execution of these procedures, the procedural flow of Fig. 8 starts. First, at step S81, cheeking is made to see if there is an excess in the number of air conditioning units operating in the current state of operation of servers. A way of this checking makes comparison between a maximum amount of heat generated by the servers in operation, acquired beforehand, and a maximum cooling capacity of the air conditioning units in operation. Alternatively, at the discretion of an operator responsible for system operation, it may be decided whether the of air conditioning units in operation is excessive. If operation has been performed previously, by referring to a server and air conditioning unit activation/deactivation order storing device 103, it may be decided whether the number of air conditioning units in operation is excessive. As a result of such decision, if the number of air conditioning units is not excessive (No), the procedural flow terminates and the current state of operation of air conditioning units is maintained. If it has been decided that the number of air conditioning units is excessive (Yes), at step S82, reference is made to the server and air conditioning unit activation/deactivation order storing device 103 and, if an air conditioning unit to be deactivated next is determined (Yes) the procedure jumps to step S87. If an air conditioning unit to be deactivated next is not determined, step S83 and subsequent steps executed. While deactivating air conditioning units in operation one by one at step S83, the intake air temperatures of the respective servers are acquired. Information on the acquired intake air temperatures is aggregated at step S84 and an air conditioning unit, deactivation of which brought a result of minimizing a maximum value of the intake air temperatures, is determined as the air conditioning unit to be deactivated next at step S85. At step S86, information on the air conditioning unit determined to be deactivated is stored in the server and air conditioning unit activation/deactivation order storing device 103. At step S87, the determined air conditioning unit is deactivated and the process returns to the first step S81. By repeating this loop, it is possible to determine a state of operation of air conditioning units optimal for the current state of operation of servers, when activating a. new server has been requested by the server load increase/decrease noticing device 101 during the execution of this procedural flow for determining a state of operation of air conditioning units, it will be expedient to stop the ongoing process and start the procedural flow of Fig. 3.

## Claims

1. A load allocation method for allocating loads to information processing devices (13) in an open air cooled information processing system that takes in open air and cools a plurality of information processing devices (13) by single air blowing unit (10), wherein the information processing devices (13) are each positioned across an interface between one space into which open air is taken in and another space into which air after cooling the information processing devices (13) is collected, the load allocation method comprising the steps of:
when decreasing the number of servers (13) in operation, determining which one of the servers (13) in operation should be deactivated so as to minimize electric power consumed by the air blowing unit (10) by way of numerical analysis performed individually on each of the servers (13) in operation and according to a change in intake air temperature of each server (13) and deactivating the one of the servers (13); and
when increasing the number of servers (13) in operation, determining which one of the servers (13) out of operation should be activated so as to minimize electric power consumed by the air blowing unit (10) by way of numerical analysis in an inoperative status performed individually on each of the servers (13) out of operation and according to a change in the intake air temperature of each server (13), and activating the one of the servers (13).

2. The load allocation method in the open air cooled information processing system according to claim 1,
wherein the numerical analysis is performed before start of operation, and
wherein the load allocation method comprises the steps of:
setting, as a first server (13), a server (13) when activated that is determined to bring a result of minimizing the electric power consumed by the air blowing unit (10) and not to make an abnormal change of the intake air temperature of the server (13), assuming a case where one server (13) has been activated from a state in which all severs (13) are inoperative;
setting, as a second server (13), a server (13) when activated that brings a result of minimizing the electric power consumed by the air blowing unit (10) and does not make an abnormal change of the intake air temperature of the server (13), assuming case where one server (13) has further been activated from a state in which the first server is operative;
setting, as an n-th server (13) (where n is a natural number smaller than the number of all servers (13)), a server (13) when activated that brings a result of minimizing the electric power consumed by the air blowing unit (10) and does not make an abnormal change of the intake air temperature of the server (13), assuming a case where an (n+1) th server (13) has been activated from a state in which the n-th server (13) is operative; and
repeating the step of setting a server (13) as the n-th server (13) until a state in which only one of all servers (13) is operative and storing an order of the servers (13) thus obtained

3. An open air cooled information processing system that takes in open air and cools a plurality of information processing devices (13) by single air blowing unit (10),
wherein the information processing devices (13) are each positioned across an interface between one space (12) into which open air is taken in and another space (14) into which air after cooling the information processing devices (13) is collected,
wherein each of the servers (13) includes means (105) for measuring its intake air temperature,
the open air cooled information processing system comprising:
means (102) for, when decreasing the number of servers (13) in operation, determining which one of the servers (13) in operation should be deactivated so as to minimize electric power consumed by the air blowing unit (10) by way of numerical analysis performed individually on each of the servers (13) in operation and according to a change in the intake air temperature of each server (13), and deactivating the one of the servers (13); and
means (102) for, when increasing the number of servers in operation, determining which one of the servers (13) out of operation should be activated so as to minimize electric power consumed by the air blowing unit (10) by way of numerical analysis in an inoperative status performed individually on each of the servers (13) out of operation and according to a change in the intake air temperature of each server (13), and activating the one of the servers (13).

4. A load allocation method for allocating loads to information processing devices (13) in a locally coolable information processing system including a plurality of information processing devices (13) and a plurality of air conditioning units (15) in a closed room, the information processing system having a space (12) into which air conditioning units (15) discharge cool air and from which the information processing devices (13) take in air and a space (14) into which the information processing devices (13) discharge heared air and from which the air conditioning units (15) take in air, these spaces (12, 14) being isolated by structures such as housings of the information processing devices (13), the load allocation method comprising the steps of:
when decreasing the number of servers (13) in operation, determining which one of the servers (13) in operation should be deactivated so as to minimize electric power consumed by the air blowing unit (10) by way of numerical analysis performed individually on each of the servers (13) in operation and according to a change in intake air temperature of each server (13) and deactivating the one of the servers (13);
when increasing the number of servers (13) in operation, determining which one of the servers (13) out of operation should be activated so as to minimize electric power consumed by the air blowing unit (10) by way of numerical analysis in an inoperative status performed individually on each of the servers (13) out of operation and according to a change in the intake air temperature of each server (13), and activating the one of the servers (13); and
from a state in which an excessive number of air conditioning units (15) are operating in the operative/inoperative statuses of the plurality of air conditioning units (15), determining an order of air conditioning units (15) to be deactivated by determining which one air conditioning unit (15), when deactivated, brings the best result to suppress an increase of a maximum value of inlet air temperatures of the servers (13) and operating the air conditioning units (15) according to the order.
